Europäisches Patentamt

European Patent Office

Office européen des brevets

(19)

(11) Veröffentlichungsnummer : **0 176 821**
**B1**

(12)

# EUROPÄISCHE PATENTSCHRIFT

(45) Veröffentlichungstag der Patentschrift :
24.01.90

(51) Int. Cl.⁵ : **H 03 M   3/04**

(21) Anmeldenummer : **85111425.6**

(22) Anmeldetag : **10.09.85**

(54) DPCM-Codierer mit verringerter interner Rechenzeit.

(30) Priorität : **14.09.84 DE 3433840**

(43) Veröffentlichungstag der Anmeldung :
**09.04.86 Patentblatt 86/15**

(45) Bekanntmachung des Hinweises auf die Patenterteilung : **24.01.90 Patentblatt 90/04**

(84) Benannte Vertragsstaaten :
**AT BE CH DE FR GB IT LI NL SE**

(56) Entgegenhaltungen :
**DE--A-- 2 260 264**
**DE--A-- 2 316 639**
**DE--A-- 3 232 516**
**DE--A-- 3 239 841**
**GLOBECOM '82, IEEE GLOBAL TELECOMMUNICA-**
**TIONS CONFERENCE, CONFERENCE RECORD,**
**Band 1, 29. November - 2. Dezember 1982, Miami, US,**
**Seiten 246-248, IEEE, New York, US; R. MARUTA u.a.:**
**"Per-channel ADPCM codec for multi-purpose appli-**
**cations"**

(73) Patentinhaber : **Siemens Aktiengesellschaft**
**Wittelsbacherplatz 2**
**D-8000 München 2 (DE)**

(72) Erfinder : **Grallert, Hans-Joachim, Dr.-Ing.**
**Tannenfleckstrasse 30**
**D-8038 Gröbenzell (DE)**

**Beschreibung**

Die Erfindung betrifft einen DPCM-Codierer mit verringerter interner Rechenzeit.

Bei der digitalen Übertragung und Speicherung von Signalen wird häufig das Differenz-Puls-Code-Modulationsverfahren (DPCM) angewendet. Dabei wird für jeden aktuellen Abtastwert $s_i$ aus vorhergehenden Abtastwerten ein Schätzwert $\hat{s}_i$ berechnet. Die Differenz $\Delta s_i = s_i - \hat{s}_i$ wird quantisiert und anschließend übertragen. Durch dies Verfahren wird erreicht, daß zur Darstellung von $\Delta s_i$ eine kleinere Wortlänge verwendbar ist, als zur Darstellung der PCM-codierten Abtastwerte $s_i$ erforderlich ist. Die notwendige Übertragungsrate bzw. der Speicherplatzbedarf werden dadurch wesentlich verringert. Bei einem üblichen DPCM-Codierer, wie er beispielsweise in Fig. 1 der DE-A1-32 32 516 dargestellt ist, sind zur Verarbeitung der Abtastwerte $s_i$ innerhalb eines Abtastintervalls $t_A$ vier Rechenoperationen erforderlich. Diese Rechenoperationen bestehen aus einer Subtraktion, einer Quantisierung, einer Addition und einer Multiplikation. In der Offenlegungsschrift DE-A1-32 32 516 wurde die interne Rechenzeit durch einen umfangreicheren Quantisierer und durch mehrere Rechenschleifen verringert.

Aufgabe der Erfindung ist es einen mit geringem Aufwand realisierbaren DPCM-Codierer mit verringerter interner Rechenzeit anzugeben.

Diese Aufgabe wird durch die Kombination der technischen Merkmale des Patentanspruchs 1 gelöst.

Vorteilhafte Ausbildungen der Erfindung sind in den Unteransprüchen angegeben.

Bei dem erfindungsgemäßen DPCM-Codierer ist Voraussetzung, daß als Prädiktionsfaktor $a = 1 : 2^n$, $n = 1, 2, 3...$ vorgesehen ist. In diesem Fall entfällt die Rechenzeit des Multiplizierers, da dieser durch eine entsprechende Verdrahtung realisierbar ist.

Ein Ausführungsbeispiel der Erfindung wird anhand der Figuren 1 bis 3 näher erläutert.

Es zeigen

Fig. 1 ein Prinzipschaltbild des DPCM-Codierers,

Fig. 2 eine Variante des DPCM-Codierers,

Fig. 3 die Realisation der Multiplizierer durch Verdrahtung und

Fig. 4 ein Zeitdiagramm zu Fig. 1.

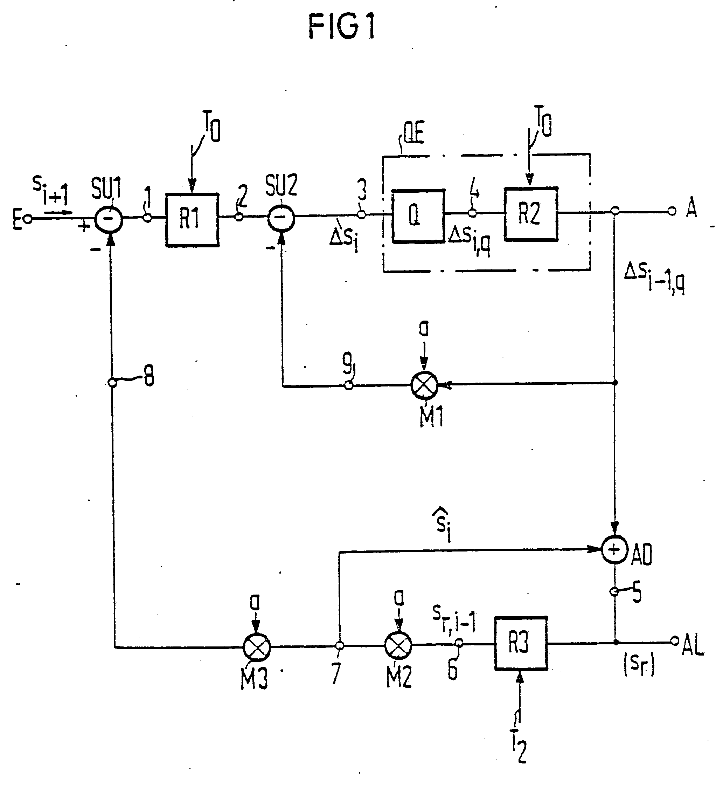

Am Eingang eines in Fig. 1 dargestellten DPCM-Codierers liegen die digitalisierten Abtastwerte $s_i$ an. Der Eingang E ist mit einem ersten Subtrahierer SU1 verbunden, dessen Ausgang über ein erstes Register R1 mit einem Eingang eines zweiten Subtrahierers SU2 verbunden ist. Dessen Ausgang ist mit dem Eingang einer Quantisiereinrichtung QE verbunden, deren Ausgang gleichzeitig den Signalausgang A des DPCM-Codierers bildet, an dem die DPCM-Werte $\Delta s_{i,q}$ abgegeben werden. Die Quantisiereinrichtung QE enthält einen Quantisierer Q mit einem nachgeschalteten zweiten Register R2. Als Quantisierer Q kann ein Gatternetzwerk oder ein Lesespeicher Verwendung finden.

Der Signalausgang A ist über einen ersten Multiplizierer M1 auf den Subtraktionseingang des zweiten Subtrahierers SU2 rückgekoppelt. Alle hier verwendeten Multiplizierer multiplizieren die Eingangswerte mit einem konstanten Prädiktionsfaktor a.

Der Signalausgang A ist außerdem über einen Addierer AD, ein drittes Register R3, einem zweiten Multiplizierer M2 und einen dritten Multiplizierer M3 auf den Subtraktionseingang des ersten Subtrahierers SU1 rückgekoppelt. Der Ausgang des zweiten Multiplizierers M2 ist außerdem auf den zweiten Eingang des Addierers AD geführt. Der Ausgang des Addierers AD bildet gleichzeitig den sogenannten lokalen Ausgang AL, an dem die rekonstruierten Werte $s_r$ anliegen, die beispielsweise zur Steuerung des Quantisierers oder bei einer mehrdimensionalen DPCM-Schleife benötigt werden. Als lokaler Ausgang kann selbstverständlich auch der Ausgang des dritten Registers R3 verwendet werden.

Zunächst soll die Funktion des DPCM-Codierers theoretisch behandelt werden. Der DPCM-Codierer soll an seinem Ausgang DPCM-Werte $\Delta s_{i,q}$ liefern, die durch Quantisierung der errechneten DPCM-Signale $\Delta s_i$ gewonnen werden. Als Gleichung für die Berechnung des DPCM-Signals $\Delta s_i$ gilt

(F1)
$$\Delta s_i = s_i - \hat{s}_i,$$

wobei für die Berechnung des Schätzwertes $\hat{s}_i$ gilt

(F2)
$$\hat{s}_i = a(\hat{s}_{i-1} + \Delta s_{i-1,q}),$$

(F3)
$$\hat{s}_{i-1} = a(\hat{s}_{i-2} + \Delta s_{i-2,q})$$

mit (F3) in (F2) eingesetzt

(F4)
$$\hat{s}_i = a[a(\hat{s}_{i-2} + \Delta s_{i-2,q}) + \Delta s_{i-1,q}]$$

(F5)
$$\hat{s}_i = a^2(\hat{s}_{i-2} + \Delta s_{i-2,q}) + a\,\Delta s_{i-1,q}$$

(F6)
$$\hat{s}_i = a\hat{s}_{i-1} + a\,\Delta s_{i-1,q}$$

2

Der Vollständigkeit halber wird für den am lokalen Ausgang abgegebenen rekonstruierten Wert angegeben :

(F7)
$$s_{r,i} = \hat{s}_i + \Delta s_{i,q} = a(s_{i-1} + \Delta s_{i-1,q}) + \Delta s_{i,q}$$

In dem DPCM-Codierer wird der Schätzwert $\hat{s}_i$ entsprechend F5 bzw. F6 berechnet. Für das DPCM-Signal ergibt sich somit

(F8)
$$\Delta s_i = s_i - a\hat{s}_{i-1} - a\,\Delta s_{i-1,q}$$

Die Formel besagt, daß das aktuelle DPCM-Signal durch Subtraktion der angegebenen Terme vom aktuellen Abtastwert $s_i$ ermittelt wird.

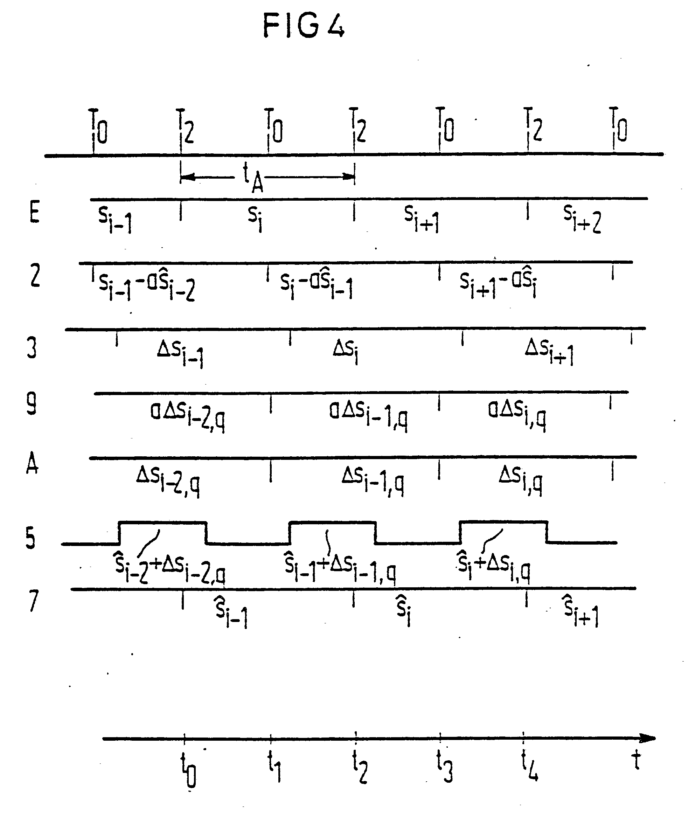

Bevor die Funktion des DPCM-Codierers anhand des in Fig. 4 dargestellten Zeitdiagramms näher erläutert wird, sollen zunächst noch einige Voraussetzungen gemacht werden. Als Speicher R1 bis R3 werden Register verwendet, die durch Taktimpulse $T_0$ und $T_2$ gesteuert werden. Jeweils am Ende des Taktimpulses ändert sich die Information am Ausgang der Register. Es ist selbstverständlich, daß an Stelle der Register Laufzeitglieder oder andere Speicher verwendet werden können. Die Multiplizierer M1 bis M3 weisen keinerlei Laufzeit auf, da sie durch eine entsprechende Verdrahtung realisiert sind. Die angegebenen Signalbezeichnungen gelten für einen Zeitpunkt unmittelbar vor dem Zeitpunkt $t_3$ unmittelbar vor einem Taktimpuls $T_0$. Im Zeitdiagramm ist zunächst das Auftreten der Taktimpulse $T_0$ und $T_2$ dargestellt. Wichtige Stellen in der Schaltung sind mit Ziffern bezeichnet, die im Zeitdiagramm ebenfalls dargestellt sind. Es erscheint zweckmäßig, die Berechnung des im DPCM-Codierer dargestellten DPCM-Signals $\Delta s_i$ von dem Zeitpunkt an zu verfolgen, an dem der zugehörige Abtastwert $s_i$ am Eingang E anlag. Dieser Zeitpunkt ist im Zeitdiagramm mit $t_0$ bezeichnet, er entspricht einem Taktimpuls $T_2$. Mit demselben Taktimpuls wird in das dritte Register R3 der Rechenwert

(9)
$$s_{i-2} + \Delta s_{i-2,q}$$

übernommen und mit dem Quadrat des Prädiktionsfaktors a multipliziert, so daß am Subtraktionseingang — 8 — des ersten Subtrahierers der Term

(10)
$$as_{i-1}$$

gleichzeitig mit dem Signalwert $s_i$ am Eingang E anliegt. Die Differenz

(11)
$$s_i - a\hat{s}_{i-1}$$

am Ausgang des ersten Subtrahierers SU1 wird mit dem nächsten Taktimpuls $T_0$ zum Zeitpunkt $t_1$ in das erste Register R1 übernommen. Mit diesem Taktimpuls $T_0$ ändert sich gleichzeitig das DPCM-Signal am Ausgang des zweiten Registers R2, an dem der dargestellte DPCM-Wert

(12)
$$\Delta s_{i-1,q}$$

erscheint. Am Ausgang des Addierers AD — mit 5 bezeichnet — erscheint nach kurzer Laufzeit der rekonstruierte Signalwert

(13)
$$s_{r,i-1} = \hat{s}_{i-1} + \Delta s_{i-1,q} \cdot$$

Dieser wird mit dem nächsten Taktimpuls $T_2$ zum Zeitpunkt $t_2$ in das dritte Register R3 übernommen und erscheint mit dem Prädiktionsfaktor a als aktueller Schätzwert $s_i$ am Ausgang 7 des zweiten Multiplizierers M2.

Mit dem Taktimpuls $T_0$ zum Zeitpunkt $t_1$ ändert sich, wie bereits erwähnt, das DPCM-Signal am Ausgang A und somit gleichzeitig, da der erste Multiplizierer M1 keinerlei Rechenzeit benötigt, auch der Eingangswert am Subtraktionseingang des zweiten Subtrahierers SU2, im Zeitdiagramm mit 9 bezeichnet. Nach einer kurzen Laufzeit des zweiten Subtrahierers SU2 liegt das errechnete DPCM-Signal $\Delta s_i$ am Eingang des Quantisierers Q an, von dessen Ausgang der quantisierte DPCM-Wert $\Delta s_{i,q}$ mit dem nächsten Taktimpuls $T_0$ zum Zeitpunkt $t_3$ an den Ausgang A des DPCM-Codierers gelangt. Innerhalb eines Abtastintervalls $t_a$ werden in der äußeren Schleife eine Addition im Addierer AD und eine Subtraktion im ersten Subtrahierer SU1 durchgeführt. Diese Rechenoperationen sind zeitlich unkritisch. Zeitkritisch sind dagegen die Rechenoperationen in der inneren Rechenschleife mit dem zweiten Subtrahierer SU2, dem Quantisierer Q und dem ersten Multiplizierer M1. Am zeitaufwendigsten ist hier die Quantisierung. Da der erste Multiplizierer M1 keinerlei Rechenzeit benötigt, sind während eines Abtastintervalls nunmehr nur zwei Rechenoperationen, nämlich eine Subtraktion im zweiten Subtrahierer SU2 und die Quantisierung notwendig.

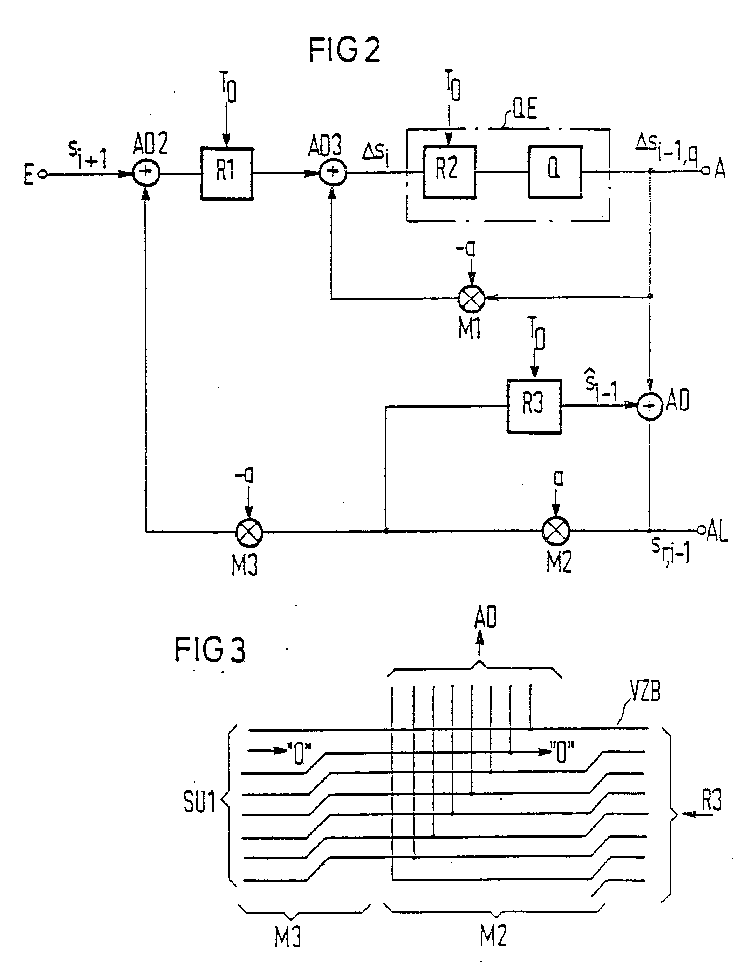

Selbstverständlich kann die Reihenfolge von Multiplizierern und Registern vertauscht werden, beispielsweise beim dritten Register R3 und dem zweiten Multiplizierer M2. Ebenso ist es denkbar, das dritte Register R3 unmittelbar vor den Eingang des Addierers AD in der Rückführung vom Ausgang des zweiten Multiplizierers M2 einzuschalten (Fig. 2). In diesem Fall sollen sich die Abtastwerte $s_i$ am Eingang E mit dem Taktimpuls $T_0$ ändern.

Ebenso kann die Reihenfolge von Quantisierer Q und zweiten Register R2 vertauscht werden. Dann erhält man eine Quantisiereinheit QE, deren Funktion den heute handelsüblichen Lesespeichern (ROM, PROM) entspricht (Die dargestellten Register werden nicht benötigt, wenn sie bereits in den Rechenschaltungen vorgesehen sind).

An dem lokalen Ausgang AL liegen beim DPCM-Codierer nach Fig. 1 die rekonstruierten Abtastwerte $s_r$ nur ca. zwischen den beiden Taktimpulsen $T_0$ und $T_2$ an. Sie können jedoch am Ausgang des dritten Registers R3 abgenommen werden. Wird das dritte Register R3 dagegen in die Rückführung vom Ausgang des zweiten Multiplizierers M2 vor dem Addierer AD eingeschaltet, so liegen die rekonstruierten Abtastwerte $s_r$ — von der Rechenzeit des Addierers AD abgesehen — ständig am lokalen Ausgang an. In diesem Fall arbeitet auch das dritte Register R3 mit dem Taktimpuls $T_0$ und die Abtastwerte am Eingang E ändern sich ebenfalls mit diesen Taktimpuls. Das entsprechende Ausführungsbeispiel ist in der Fig. 2 dargestellt. In diesem Ausführungsbeispiel sind auch die Subtrahierer SU1 und SU2 durch einen zweiten Addierer AD2 bzw. einen dritten Addierer AD3 ersetzt. Diesen Addierern wird jeweils das Zweierkomplement der ursprünglichen Zahlenwerte — symbolisiert durch einen negativen Prädiktionsfaktor « -a » — des ersten und des dritten Multiplizierers M1, M3 zugeführt.

In Fig. 3 ist die Realisation der Multiplizierer durch eine spezielle Verdrahtung dargestellt. In diesem Beispiel soll mit dem Faktor 1/2 multipliziert werden. Der zweite Multiplizierer M2 wird dadurch realisiert, daß alle Bits bis auf das Vorzeichenbit VZB um eine Binärstelle verschoben werden und als nach dem Vorzeichenbit VZB höchstwertiges Bit eine binäre « 0 » eingesetzt wird. Dieser Vorgang wiederholt sich nochmals bei dem zweiten Multiplizierer M3. Ebenso kann bei der Verwendung von Zweierkomplementen verfahren werden, wobei jedoch das nach dem Vorzeichenbit höchstwertige Bit durch eine binäre « 1 » ergänzt wird. Die bezeichnungen an den Leitungen weisen auf die angeschlossenen Bauelemente hin.

**Patentansprüche**

1. DPCM-Codierer mit verringerter interner Rechenzeit, der folgende Merkmale aufweist:

a) einer Quantisierungseinrichtung (QE) ist ein zweiter Subtrahierer (SU2) vorgeschaltet, dem wiederrum ein erster Subtrahierer (SU1) vorgeschaltet ist, dem die digitalisierten Abtastwerte $(s_i)$ zugeführt werden,

b) der Ausgang (A) der Quantisierungseinrichtung (QE), an dem die quantisierten DPCM-Werte ($\Delta s_i$, q) abgegeben werden, ist über einen ersten Multiplizierer (M1) mit dem Subtraktionseingang des zweiten Subtrahierers (SU2) verbunden,

c) der Ausgang (A) ist außerdem mit dem ersten Eingang eines Addierers (AD) verbunden, dessen Ausgang über einen zweiten Multiplizierer (M2) und einen Speicher (R3) auf den zweiten Eingang des Addierers (AD) zurückgeführt ist,

d) der Ausgang des zweiten Multiplizierers (M2) ist über einen dritten Multiplizierer (M3) an den Subtraktionseingang des ersten Subtrahierers (SU1) angeschlossen und

e) an allen Multiplizierern (M1 bis M3) liegt als Multiplikator ein konstanter Prädiktionsfaktor $a = 1/2^n$ (n = 0, 1, 2, 3...) an.

2. DPCM-Codierer nach Anspruch 1, dadurch gekennzeichnet, daß ein erster Speicher (R1) zwischen dem ersten Subtrahierer (SU1) und dem zweiten Subtrahierer (SU2) angeordnet ist.

3. DPCM-Codierer nach Anspruch 1, dadurch gekennzeichnet, daß ein dritter Speicher (R3) zwischen dem Ausgang des Addierers (AD) und dem Eingang des dritten Multiplizierers (M3) angeordnet ist.

4. DPCM-Codierer nach Anspruch 1, dadurch gekennzeichnet, daß die Quantisierereinheit (QE) die Reihenschaltung eines Quantisierers (Q) und eines Speichers (R2) oder umgekehrt enthält.

5. DPCM-Codierer nach Anspruch 1, dadurch gekennzeichnet, daß der dritte Speicher (R3) dem zweiten Eingang des Addierers (AD) vorgeschaltet ist.

6. DPCM-Codierer nach Anspruch 1, dadurch gekennzeichnet, daß als Speicher (R1 bis R3) taktgesteuerte Register vorgesehen sind.

7. DPCM-Codierer nach Anspruch 1, dadurch gekennzeichnet, daß taktgesteuerte Addierer (AD) und Subtrahierer (SU) vorgesehen sind.

8. DPCM-Codierer nach Anspruch 1, dadurch gekennzeichnet, daß als Subtrahierer (SU1, SU2) weitere Addierer (AD2, AD3) vorgesehen sind, denen die zu subtrahierenden Rechenwerte als Zweierkomplement zugeführt werden.

9. DPCM-Codierer nach Anspruch 1, dadurch gekennzeichnet, daß die Multiplizierer (M1 bis M3) durch eine entsprechende Verdrahtung realisiert sind.

10. DPCM-Codierer nach Anspruch 2, Anspruch 3 und Anspruch 6, dadurch gekennzeichnet, daß an dem ersten Speicher (R1) und dem zweiten Speicher (R2) derselbe Taktimpuls $(T_0)$ anliegt und an dem dritten Speicher (R3) ein hierzu um ca. 180° phasenverschobener Taktimpuls (T2) anliegt.

4

## EP 0 176 821 B1

### Claims

1. DPCM coder with reduced internal computing time, having the following features :

a) preceding a quantization device (QE) there is a second subtracter (SU2) which in turn is preceded by a first subtracter (SU1) to which the digitized sampled values ($s_i$) are fed,

b) the output (A) of the quantization device (QE), at which the quantized DPCM values ($\Delta s_i$, q) are output, is connected via a first multiplier (M1) to the subtraction input of the second subtacter (SU2),

c) the output (A) is further connected to the first input of an adder (AD) whose output is fed back via a second multiplier (M2) and a memory (R3) to the second input of the adder (AD),

d) the output of the second multiplier (M2) is connected via a third multiplier (M3) to the subtraction input of the first subtracter (SU1), and

e) a constant prediction factor $a = 1/2^n$ ($n = 0, 1, 2, 3...$) is applied as multiplier to all multipliers (M1 to M3).

2. DPCM coder according to Claim 1, characterized in that a first memory (R1) is arranged between the first subtracter (SU1) and the second subtracter (SU2).

3. DPCM coder according to Claim 1, characterized in that a third memory (R3) is arranged between the output of the adder (AD) and the input of the third multiplier (M3).

4. DPCM coder according to Claim 1, characterized in that the quantization unit (QE) contains the series circuit of a quantizer (Q) and a memory (R2) or vice versa.

5. DPCM coder according to Claim 1, characterized in that the third memory (R3) precedes the second input of the adder (AD).

6. DPCM coder according to Claim 1, characterized in that clock-controlled registers are provided as memories (R1 to R3).

7. DPCM coder according to Claim 1, characterized in that clock-controlled adders (AD) and subtracters (SU) are provided.

8. DPCM coder according to Claim 1, characterized in that further adders (AD2, AD3) are provided as subtracters (SU1, SU2), to which the computing margins to be subtracted are fed as two's, complement.

9. DPCM coder according to Claim 1, characterized in that the multipliers (M1 to M3) are realized by a corresponding wiring.

10. DPCM coder according to Claim 2, Claim 3 and Claim 6, characterized in that the same clock pulse ($T_0$) is applied to the first memory (R1) and to the second memory (R2), and a clock pulse (T2) phase-shifted by approximately 180° hereto is applied to the third memory (R3).

### Revendications

1. Codeur MICD à temps de calcul interne réduit, présentant les caractéristiques suivantes :

a) en amont d'un dispositif de quantification (QE) est branché un second soustracteur (SU2), en aval duquel est à nouveau branché un premier soustracteur (SU1), auquel sont envoyées les valeurs d'échantillonnage numérisées ($s_i$),

b) la sortie (A) du dispositif de quantification (QE), sur laquelle les valeurs MICD quantifiées ($\Delta s_i$, q) sont délivrées, est reliée par l'intermédiaire d'un premier multiplicateur (M1) à l'entrée de soustraction du second soustracteur (SU2),

c) la sortie (A) est en outre reliée à la première entrée d'un additionneur (AD), dont la sortie est reliée par réaction, au moyen d'un second multiplicateur (M2), et d'une mémoire (R3) à la seconde entrée de l'additionneur (AD),

d) la sortie du second multiplicateur (M2) est raccordée par l'intermédiaire d'un troisième multiplicateur (M3) à l'entrée de soustraction du premier soustracteur (SU1), et

e) un facteur constant de prédiction $a = 1/2^n$ ($n = 0, 1, 2, 3...$) est appliqué, en tant que coefficient multiplicateur, à tous les multiplicateurs (M1 à M3).

2. Codeur MICD suivant la revendication 1, caractérisé par le fait qu'une première mémoire (R1) est disposée entre le premier soustracteur (SU1) et le second soustracteur (SU2).

3. Codeur MICD suivant la revendication 1, caractérisé par le fait qu'une troisième mémoire (R3) est disposée entre la sortie de l'additionneur (AD) et l'entrée du troisième multiplicateur (M3).

4. Codeur MICD suivant la revendication 1, caractérisé par le fait que l'unité de quantification (QE) contient le circuit série formé d'un quantificateur (Q) et d'une mémoire (R2) ou inversement.

5. Codeur MICD suivant la revendication 1, caractérisé par le fait que la troisième mémoire (R3) est branchée en amont de la seconde entrée de l'additionneur (AD).

6. Codeur MICD suivant la revendication 1, caractérisé par le fait qu'il est prévu, comme mémoires (R1 à R3), des registres commandées de façon cadencée.

7. Codeur MICD suivant la revendication 1, caractérisé par le fait qu'il est prévu des additionneurs (AD) et des soustracteurs (SU), commandés de façon cadencée.

8. Codeur MICD suivant la revendication 1, caractérisé par le fait qu'il est prévu, comme soustracteurs (SU1, SU2), d'autres additionneurs (AD2, AD3), auxquels sont envoyées les valeurs de

5

**EP 0 176 821 B1**

calcul devant être soustraites, sous la forme de compléments à deux.

9. Codeur MICD suivant la revendication 1, caractérisé par le fait que les multiplicateurs (M1 à M3) sont constitués par un câblage correspondant.

10. Codeur MICD suivant la revendication 2, la revendication 3 et la revendication 6, caractérisé par le fait que la même impulsion de cadence ($T_0$) est appliquée à la première mémoire (R1) et à la seconde mémoire (R2) et qu'une impulsion de cadence (T2) déphasée d'environ 180° par rapport à cette impulsion est appliquée à la troisième mémoire (R3).

6

FIG 1

## FIG 2

## FIG 3

## FIG 4

$T_0 \quad T_2 \quad T_0 \quad T_2 \quad T_0 \quad T_2 \quad T_0$

$t_A$

E $\quad s_{i-1} \qquad s_i \qquad s_{i+1} \qquad s_{i+2}$

2 $\quad s_{i-1} - a\hat{s}_{i-2} \qquad s_i - a\hat{s}_{i-1} \qquad s_{i+1} - a\hat{s}_i$

3 $\quad \Delta s_{i-1} \qquad \Delta s_i \qquad \Delta s_{i+1}$

9 $\quad a\Delta s_{i-2,q} \qquad a\Delta s_{i-1,q} \qquad a\Delta s_{i,q}$

A $\quad \Delta s_{i-2,q} \qquad \Delta s_{i-1,q} \qquad \Delta s_{i,q}$

5 $\quad \hat{s}_{i-2} + \Delta s_{i-2,q} \qquad \hat{s}_{i-1} + \Delta s_{i-1,q} \qquad \hat{s}_i + \Delta s_{i,q}$

7 $\quad \hat{s}_{i-1} \qquad \hat{s}_i \qquad \hat{s}_{i+1}$

$t_0 \quad t_1 \quad t_2 \quad t_3 \quad t_4 \qquad t$